# EUROPEAN PATENT SPECIFICATION

(11) **EP 0 289 013 B1**
(45) Date of publication and mention of the grant of the patent: **22.09.1993**
(21) Application number: 88106792.0
(22) Date of filing: 28.04.1988
(51) Int. Cl.: H05B 6/66, H02M 3/335

(54) **A power supply for a magnetron**
Leistungsversorgung für Magnetron
Alimentation de puissance pour magnétron

(30) Priority: 30.04.1987 JP 106636/87; 30.04.1987 JP 106637/87
(43) Date of publication of application: 02.11.1988
(73) Proprietor: MATSUSHITA ELECTRIC INDUSTRIAL CO., LTD., Kadoma-shi, Osaka-fu, 571 (JP)
(72) Inventor: Matsumoto, Takahiro, Ikoma-gun Nara-ken (JP); Suenaga, Haruo, Soraku-gun Kyoto-fu (JP); Maehara, Naoyoshi, Shiki-gun Nara-ken (JP); Sakamoto, Kazuho, Soraku-gun Kyoto-fu (JP); Niwa, Takashi, Ikoma-gun Nara-ken (JP); Kusunoki, Shigeru, Yamatokoriyama-shi Nara-ken (JP); Shitaya,Takao, Yamatokoriyama-shi Nara-ken (JP); Bessyo, Daisuke, Yamatokoriyama-shi Nara-ken (JP)
(74) Representative: Eisenführ, Speiser & Partner

(56) References cited:
- FR-A- 2 324 116
- US-A- 4 318 165

## Description

The invention relates to a power supply for a magnetron comprising a d.c. power supply, an inverter having at least one switching element for converting the output of the d.c. power supply into high frequency, a drive circuit for the inverter, and a transformer which boosts the output of the inverter to feed power to the magnetron; the transformer comprising a primary winding to be connected with the inverter, a secondary winding for feeding high-tension high-frequency power to the magnetron, a tertiary winding for feeding low-tension high-frequency to the cathode heater of the magnetron, and a fourth winding for providing a voltage signal to the drive circuit for controlling the output voltage of the inverter; further comprising a current sensor for providing a current signal to the drive circuit for controlling the output current of the inverter. Such a power supply is already known from US-A-4 318 165.

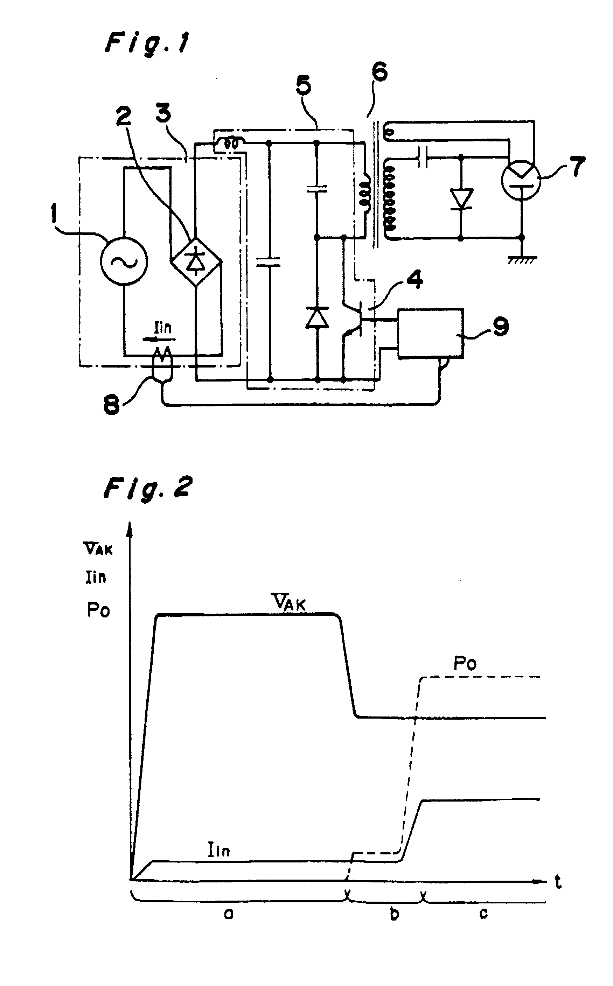

Fig. 1 shows a circuit diagram of a magnetron power supply for a conventional high-frequency heating apparatus. The power of a commercial power-supply 1 is rectified by a diode bridge 2 to provide a d.c. power supply 3. The power of the d.c. power supply 3 is converted into high frequency by an inverter circuit 5 including a switching element 4, is boosted by a high-tension transformer 6, and thereafter is applied to a magnetron 7. A power controlling system of this high-frequency heating apparatus uses an input current controlling system for controlling so that the input current Iᵢₙ from the commercial power supply 1 may become a given value. Namely, an inverter controlling circuit 9 receives a signal of an input current detecting portion 8 to adjust the input current Iᵢₙ to a given value. (The conduction time ratio of the switching element 4 is adjusted.)

The current flows only to the heater portion, but does not flow between the anode and the cathode before the magnetron 7 starts its oscillation with its cathode temperature sufficiently risen to a desired temperature. When the input current Iᵢₙ is controlled to the oscillating operation of the magnetron, excessive voltage is caused between the anode and the cathode to exceed the withstand voltage. Also, the service life of the magnetron 7 may becomes shorter through excessive current flowing into the heater. Accordingly, at first the input current should be controlled to a value smaller than a given value. A control portion 9 has a time controlling mechanism for switching the input current to a steady-state value after a time lapse sufficient enough to start the oscillation so as to settle the problem.

Time necessary to start the oscillation is 4 seconds when the magnetron is kept cold, 2 seconds when it is kept warm. In a case like this, with an input current controlling system by time control, time for limiting the input current to a small value is required to be set at approximately 5 seconds, i.e. longer than the maximum time (4 seconds) necessary to start the oscillation.

When the time is set like this, a time delay is required to control the input current to a small value without fail for 5 seconds even when the magnetron was warm. Accordingly, in the conventional high-frequency heating apparatus using such a control system as described hereinabove, the time difference (5-2=3 seconds) requires a period for controlling to the smaller input current although the controlling operation may be effected to the given input current, thus resulting in wasted time in high-speed cooking apparatus.

Fig. 2 shows a timing chart of input current Iᵢₙ before the oscillation of the magnetron starts, magnetron output Po, and voltage V_{AK} between the anode and the cathode. In the periods a and b, the value is restricted to a smaller input current Iᵢₙ, in which the given output Po from the magnetron is not reached, and in the period c, the output of the magnetron becomes the given value. The time necessary for the magnetron to start its oscillation is only the period of the a. The period a may be almost zero, even in the period b the current is limited, with this period being wasted.

In order to shorten the wasted time, there is a method of feeding heating power by a heater transformer separate from the high-tension transformer 6 to pre-heat the cathode of the magnetron 7 in advance. However, such an apparatus becomes larger in size and higher in cost.

Accordingly, it is extremely difficult to shorten the rising time of the cathode temperature when the cathode of the magnetron is cold, with restriction being caused in the reduction of the wasted time in the conventional construction.

During the period b of the wasted time, the input current is so restricted that no sufficient power is to the heater of the magnetron. Thus, the magnetron is oscillating with the cathode temperature being lower than the desired temperature. The emission of the cathode is likely to be low, so that the oscillation becomes unstable and causes so-called emission modulation. Accordingly, the disadvantage is so serious that the life service of the magnetron may be shortened.

Accordingly, an essential object of the present invention is to provide a power supply for a magnetron, which is capable of removing wasted time at the starting operation through the detection of the oscillation start of the magnetron. Another important aspect of the present invention is to provide a power supply for a magnetron, which is capable of preventing the magnetron from being deteriorated through the modulation.

According to the invention, a power supply for a magnetron as defined above is characterized in that the drive circuit provides an output signal that sets the current supplied through the inverter to a lower value if the output voltage of the inverter is above a given value, and to a higher value if the output voltage is below a given value; and that the coupling coefficient between the fourth winding and the secondary winding is larger than the coupling coefficient between the fourth winding and the primary winding.

Preferable embodiments are defined in the dependent claims.

These and other objects and features of the present invention will become clear from the following description taken in conjunction with the preferred embodiments thereof with reference to the accompanying drawings, in which:
Fig. 1 is a circuit diagram of a power supply for a magnetron in a conventional embodiment;
Fig. 2 is a timing chart at the magnetron oscillation start in the conventional embodiment;
Fig. 3 is a power-supply circuit diagram of a magnetron power supply in accordance with the present invention;
Fig. 4 is a secondary winding voltage waveform chart of a transformer of a magnetron power supply;
Fig. 5 is a characteristic chart of input current during oscillation, non-oscillation of the magnetron of the magnetron power supply, and the voltage between the anode and cathode;
Fig. 6 is a timing chart at the magnetron oscillation start of the power supply;
Fig. 7 is a perspective view in one embodiment of the transformer of the power supply;
Fig. 8 is a cross-sectional view of the transformer;
Fig. 9 is a power-supply circuit diagram of the magnetron power supply in another embodiment;
Fig. 10 is a power-supply circuit diagram of the magnetron power supply in an embodiment of the present invention, using a half-wave rectifier for the high voltage;
Fig. 11 is a voltage waveform chart between the anode and the cathode of the magnetron in the circuit of Fig. 10; and
Fig. 12 is a circuit diagram of the magnetron power supply in an embodiment of the present invention for effecting secondary current feedback control.

Before the description of the present invention proceeds, it is to be noted that like parts are designated by like reference numerals throughout the accompanying drawings.

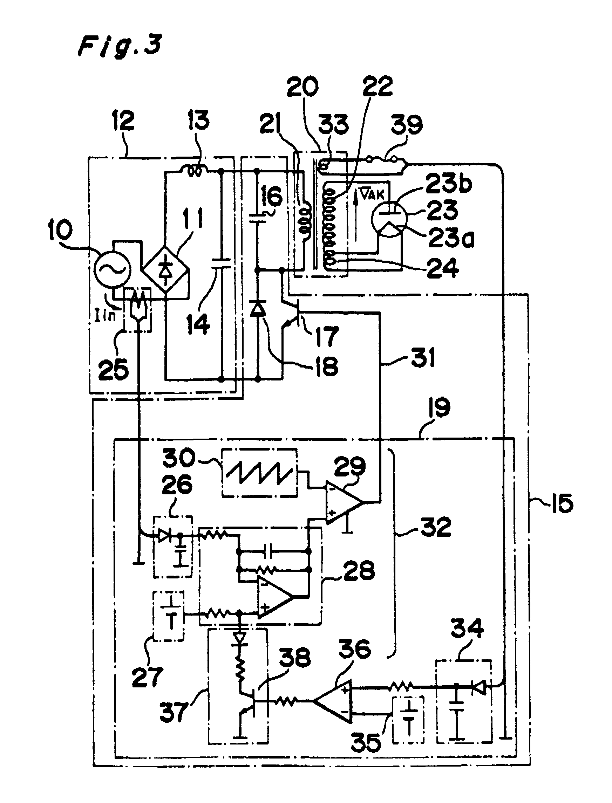

Referring now to the drawings, there is shown in Fig. 3, a circuit block diagram of a high-tension power supply generating portion for a high-frequency heating apparatus according to one preferred embodiment of the present invention. Referring to Fig. 3, the power of the commercial power supply 10 is rectified by a diode bridge 11, with a d.c. power supply 12 being formed. An inductor 13, a capacitor 14 serve as a filter with respect to the high-frequency switching operation of an inverter circuit 15.

The inverter circuit 15 is composed of a resonance capacitor 16, a power transistor 17 for switching, a diode 18 and a driving circuit 19. The power transistor 17 is switched through a given period and a duty cycle (namely, on/off time ratio) by a base current fed from the driving circuit 19. The high-frequency power is fed to the primary winding 21 of the transformer 20 so as to be transformed as high-frequency high-tension output to the secondary winding 22, so that it is fed between the cathode 23a and the anode 23b of the magnetron 23. A low-tension high-frequency power is caused in the tertiary winding 24 of the transformer 20 to heat the cathode 23a of the magnetron 23.

An input current detector 25 detects an input current Iᵢₙ from the commercial power supply 10. The difference between a current reference signal 27 and a signal obtained by rectification of the output through the input current signal rectifying circuit 26 is amplified by a current error amplifying circuit 28 and inputted into a comparator 29. The comparator 29 forms the on/off pulse for the power transistor 17 as an output signal 31 by the input signal and the saw-tooth wave from a saw-tooth wave generating circuit 30. The input current controlling portion 32 is composed of the input current detector 25 through the comparator 29. The output of the current error amplification circuit 28 is increased as the input current Iᵢₙ is decreased, with the on time of the output signal 31 of the comparator 29 being longer so that the operation is effected in such a direction as to increase the input current Iᵢₙ. Inversely, when the input current Iᵢₙ increases, an operation is effected to reduce the input current. In this manner, the input current controlling portion 32 controls so that the input current Iᵢₙ becomes a given value.

Also, as the fourth winding 33 provided on the transformer 20 has a tight coupling with the secondary winding 22, the high-tension voltage V_{AK} is detected. The signal provided through rectification of the output by the output voltage signal rectification 34 is compared with a voltage reference signal 35 by a comparator 36. The output signal of the logic circuit is inputted into a current reference signal switching circuit portion 37 to switch the current reference signal 27 in accordance with the high-tension voltage V_{AK}. Namely, as the high-tension voltage V_{AK} becomes higher with little input current Iᵢₙ before the magnetron 23 starts its oscillation, the current reference signal 27 is controlled low so as to set the voltage reference signal 35 to switch the current reference signal 27 by a transistor 38 so that the input current Iᵢₙ may increase when the high-tension voltage V_{AK} has been lowered because the magnetron 23 starts oscillation. In other words, the oscillation start of the magnetron 23 is detected by the output voltage drop of the fourth winding 33 so as to match the input current Iᵢₙ to rating. Fuse 39 is provided for protection in case the fourth winding 33 is short-circuited.

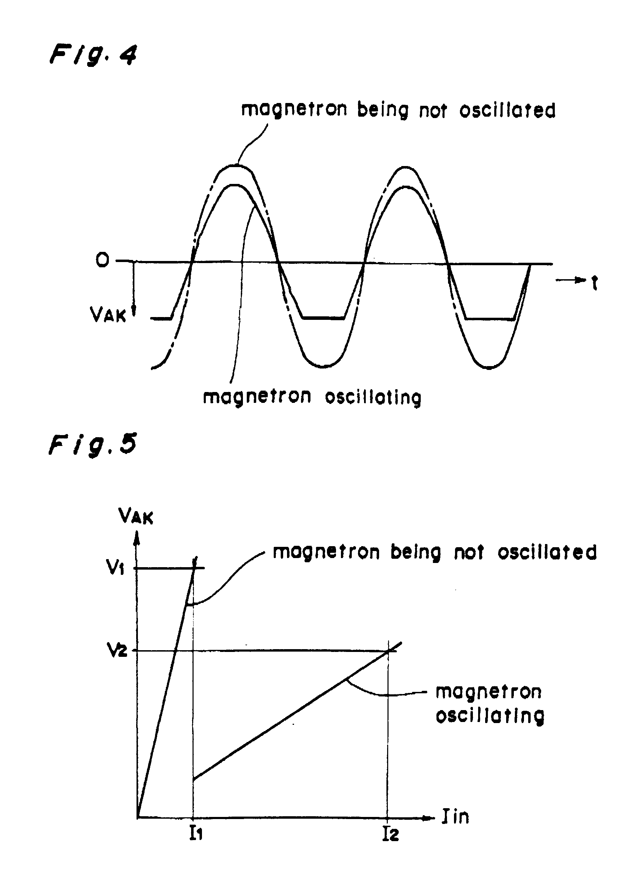

Fig. 4 shows the high-tension power supply V_{AK} voltage waveform when the magnetron 23 oscillates and when the magnetron does not oscillate, with difference therebetween being apparent. The voltage in negative direction is used for oscillating the magnetron 23. Fig. 5 shows the relationship between the input current Iᵢₙ and the voltage being defined as V_{AK}.

Referring to Fig. 5, reference character V1 is a permissible applied voltage of the magnetron 23, reference character I1 is an input current Iᵢₙ from the commercial power-supply 10 when the high-tension voltage V_{AK} is equal to V1 with the magnetron not being oscillated. Reference character V2 is a high-tension voltage V_{AK} at the rated output of the magnetron 23 and an input current Iᵢₙ at this time. The input current I1, when the magnetron 23 is not oscillated, is less than I2, while the output voltage V2, when it is oscillated, is smaller than the V1.

Accordingly, in Fig. 3, an input current detector 25 detects the input current Iᵢₙ to set the rectifying direction of the output voltage signal rectifying circuit 34 so that a voltage signal equivalent to the high-tension voltage V_{AK} may be detected by the fourth winding 33, I1 may be set at the on of the transformer 38 of a current reference signal switching circuit portion 37, I2 may be set at the off thereof. When a voltage reference signal 35 is set so as to lie between V1 and V2, the input current is controlled to I1 before the magnetron 32 starts its oscillation, and to I2 when the oscillation is started.

As the voltage reference signal 35 is set to be switched at a place where the signal becomes smaller than V1 and larger than V2 to effect such a controlling operation as described hereinabove, it is indispensable to establish V1>V2. Furthermore, it is possible to detect an oscillation of the magnetron 23 more easily if the V1/V2 is larger. The voltage signal to be expressed in the secondary winding 22 is not completely similar to each other, but it is possible to retain the relationship of V1>V2 if the coupling coefficient K24 of the secondary winding 22 and the fourth winding 33 is made larger, the coupling coefficient K14 of the primary winding 21 and the fourth winding 33 is made smaller. Table 1 shows the value of the V1/V2 when the K24 and K14 have been changed.

**Table 1**

| K24 | K14 | V1/V2 |
|---|---|---|
| 0.704 | 0.494 | 1.75 |
| 0.531 | 0.412 | 1.08 |
| 0.451 | 0.384 | 1.01 |
| 0.372 | 0.386 | 0.55 |
| 0.524 | 0.532 | 0.34 |

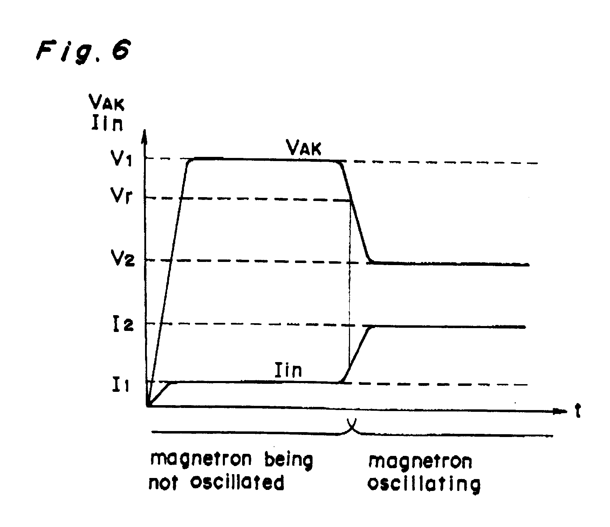

Fig. 6 is a starting characteristic graph showing the variation in the value of the V_{AK} and Iᵢₙ from the operation start of the circuit of Fig. 3. When the magnetron starts its oscillation, V_{AK} is lowered. The controlling operation is effected so that the setting value of the Iᵢₙ may be switched from I1 to I2.

In Fig. 3, a transformer is used for the detection of the input current. A method of detecting the current by the voltage drop through the insertion of a resistor into the system may be used. Also, the input current controlling portion 32 is not limited to the circuit construction shown.

Also, even when a rectifying circuit have been provided between the high-tension transformer 20 and the magnetron 23, a similar method may be adapted.

In the above-described construction, the input current Iᵢₙ is changed so that the rated output may be automatically obtained when the magnetron starts its oscillation whether the magnetron is cold or warm, so that the wasted time as in the conventional example is not caused at all, and furthermore the application of excessive voltage upon the magnetron may be prevented. Accordingly, a magnetron power supply for the high-frequency heating apparatus which is higher in reliability may be realized.

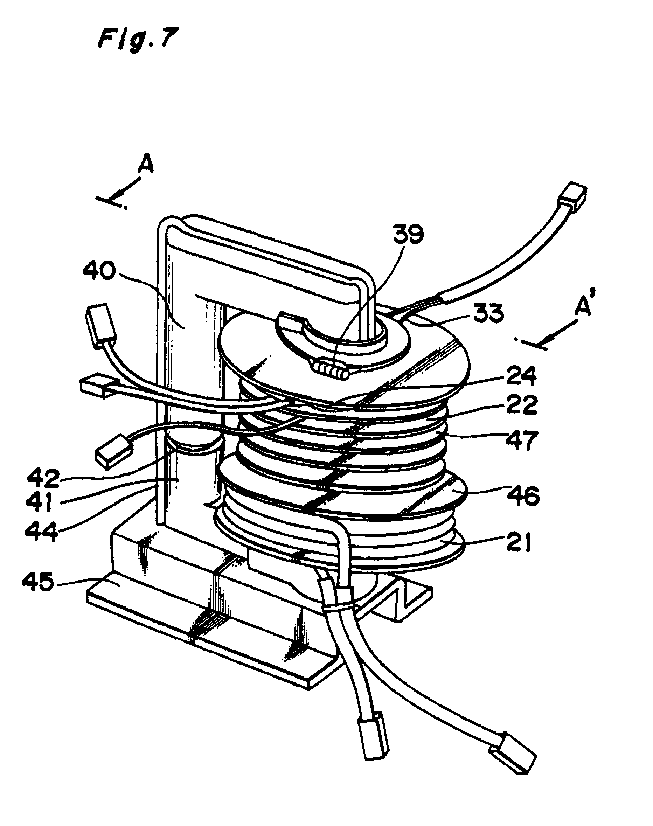

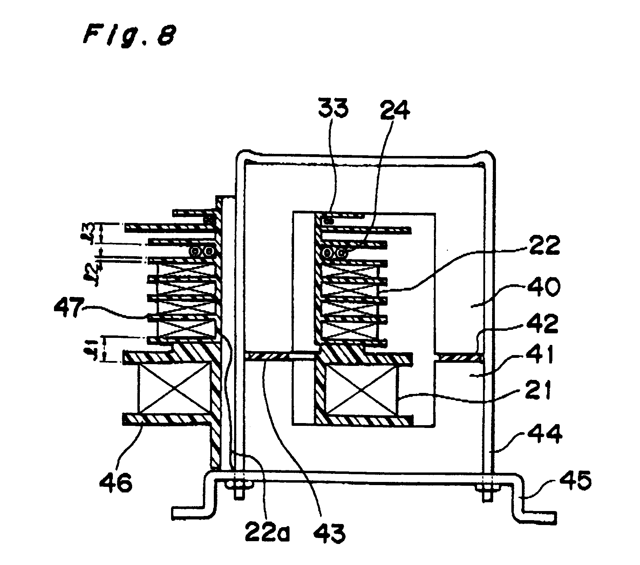

Fig. 7 is a perspective view of a transformer of a magnetron power supply of the present invention. Fig. 8 is a cross-sectional view of the embodiment of Fig. 7 taken along a line A-A'. In Fig. 7 and Fig. 8, the same reference characters are given to the components which are the same as those in Fig. 3. VR type of cores 40, 41 of the transformer are composed of ferrite material with low high-frequency loss, with gap spacers 42, 43 being between the cores to constitute a magnetic path. The cores 40, 41 are secured with a fixture 44 and a stand 45. The respective windings 21, 22, 24, 33 are wound around a primary bobbin 46 and a secondary bobbin 47 integral with a gap spacer 43 made of resin material, with sufficient space ℓ1 being provided between the primary winding 21 and the secondary winding 22. In a high-frequency heating apparatus, the anode of the magnetron and the casing are at the same potential. When the primary winding and the secondary winding are short-circuited, it is extremely dangerous to have high voltage caused in the casing. In order to prevent this danger, the space ℓ1 between the primary winding 21 and the secondary winding 22 is sufficiently made larger than the space ℓ2 between the secondary winding 22 and the tertiary winding 24. For the same reason, the space ℓ3 between the tertiary winding 24 and the fourth winding 33 is sufficiently made larger. As described hereinabove, the relationship between the coupling coefficient K14 of the primary winding 21, the fourth winding 33 and the coupling coefficient K24 between the primary winding 22 and the fourth winding 33 is K14 < K24, the windings are positioned so that the tertiary winding 24, the secondary winding 22 and the primary winding 21 are arranged in order from near the fourth winding 33 as shown in Fig. 8. As the coupling coefficient becomes generally higher if the space between the winding becomes near, K14 < K24 is naturally established in the above-described arrangement, because the secondary winding 22 is closer to the fourth winding 33 than the primary winding 21 is. As the position of the gap spacer 43 is located between the primary winding 21 and the secondary winding 22, a gap which functions to leak the magnetic path to make the coupling coefficient smaller exists between fourth winding 33 and the primary winding 21, but not between the fourth winding 33 and the secondary winding 22, with the relationship of K14 < K24 becoming obvious.

The cross-section of the conductor of the primary winding 21 becomes substantially smaller so that losses are increased because of the skin effect at high frequencies. In order to reduce the loss, so-called litz wires, which are composed of stranded fine wires each being insulated, are used. The primary winding lead is provided with protective tube to maintain the insulation. The secondary winding 22 is wounded in four split so that the withstand voltage of the secondary winding 22, reactive current is controlled to reduce the heating. The low-potential side lead 22a of the secondary winding 22 is connected with the transformer stand 45 and the cores 40, 41 for the same potential, with the potential of the cores being stabilized, thus resulting in high reliability.

As the tertiary winding 24 and the fourth winding 33 both have a low number of windings, covered wires are used to protect and insulate the outgoing lead wires, such as high-tension silicone covered wires or vinyl chloride covered wires.

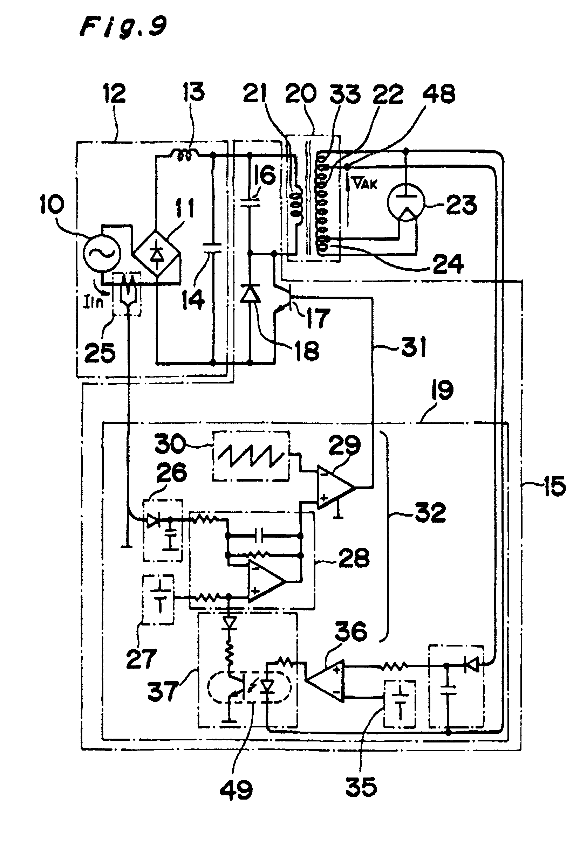

Fig. 9 shows the other embodiment, wherein the fourth winding 33 is provided by an intermediate terminal 48 on the secondary winding 22. The same reference numerals are given to the same components as those of Fig. 3. As the fourth winding 33 is provided by the intermediate terminal 48 on the secondary winding, the value is proportional to the secondary winding voltage V_{AK}. Namely, the voltage variation of the V_{AK} appears as a voltage signal divided across both the ends of the fourth winding 33. The voltage reference signal 35 which is provided by the rectification of the voltage signal through the output voltage signal rectification circuit 34 is compared with the voltage reference signal 35 by a comparator 36. The output of the logic circuit is inputted into a photo-coupler 49 of the current reference signal switching circuit portion 37 to switch the current reference signal. As the primary side of the transformer 20 is different in potential from the secondary side, it is required to transmit the signal by the photo-coupler 49. The oscillation start of the magnetron 23 is detected in this manner to perform the current controlling operation to remove the wasted time. When the fourth winding 33 has been constructed on top of the secondary winding 22, the coupling K24 between the secondary winding 22 and the fourth winding 33 becomes larger. Also, as the fourth winding is brought to the potential of the secondary winding, an insulation therebetween is unnecessary, so that the construction of the winding becomes easier to make.

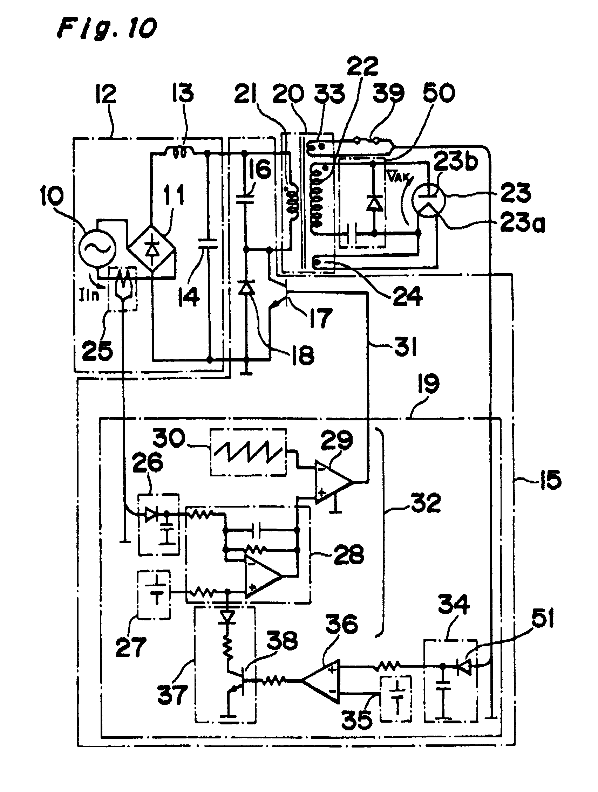

Fig. 10 is an embodiment of the circuit construction with a voltage rectification circuit 50 being provided at the high voltage side. The same reference characters are given to the same components as those of Fig. 3.

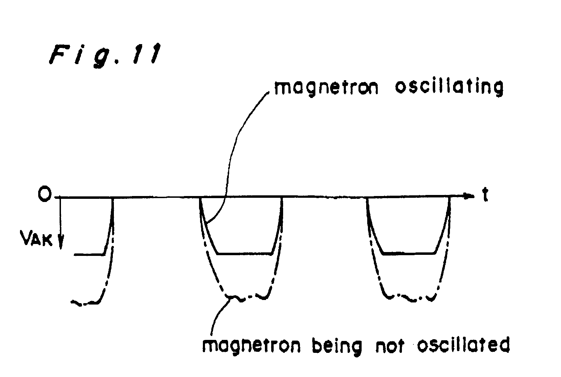

In the circuit of Fig. 10, the voltage between the cathode 23a and the anode 23b of the magnetron 23 becomes wave-shaped as shown in Fig. 11. When the magnetron 23 does not oscillate as in a case where the voltage rectification circuit shown in Fig. 4 is not used, the voltage becomes lower than when it oscillates, so that the oscillating condition of the magnetron may be detected. When a half-wave rectification circuit is provided as shown in the output voltage signal rectification circuit 34 in the case of the circuit of Fig. 10, the connection is performed in the consideration of the polarity of the fourth winding so that the diode 51 for half-wave rectification of the output voltage signal rectification circuit 34 may be conducted when the voltage of the V_{AK} has been caused. When full-wave rectification circuit is been used for the output voltage signal rectification circuit 34, the same effect may be provided without any consideration of the polarity. In this circuit construction where the secondary winding output of the transformer 20 is applied upon the magnetron 23 through voltage rectification, the wasted time at the oscillation start of the magnetron is avoided. The boosting ratio at the transformer, i.e., the primary/secondary ratio may be approximately one half in case a voltage doubler rectification circuit is used. In other words, the number of windings of the secondary winding 21 could be halved.

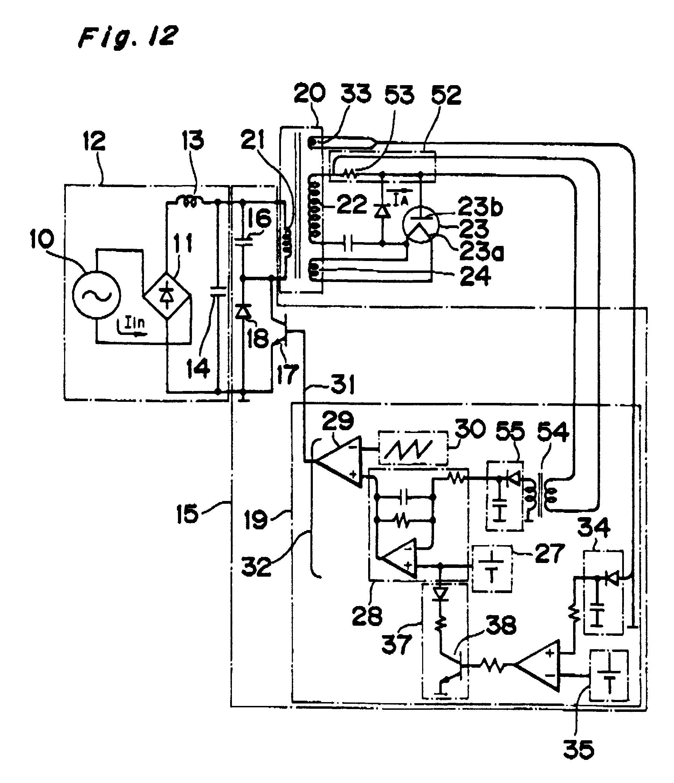

Fig. 12 shows an embodiment of the present invention using a circuit which feedbacks the current of the secondary side of the transformer to control it so as to stabilize the output of the apparatus. The same reference is given to the components which are same as those in Fig. 3.

In the circuit of Fig. 12, the input current Iᵢₙ and the anode current IA are interrelated to each other and are approximately proportional. Also, the anode current IA and the secondary current Is of the transformer are approximately proportional. Accordingly, an equal input, output control may be effected even if the secondary current Is of the transformer, instead of the input current Iᵢₙ, is detected. The secondary current detecting portion 52 rectifies the voltage caused across both ends of the resistor through an insulation transformer 54 by the secondary current signal rectification circuit 55 when the current flows to the secondary current detection resistor 53 so as to compare it with the current reference signal 27 to control the on/off ratio of the transistor 17. The circuit of Fig. 12 is equivalent to the circuit construction of Fig. 3 with the exception that the power is controlled by the secondary current Is which is approximately proportional to it, instead of the input current Iᵢₙ. It is desired that the magnetron power supply is controlled so as to be stabilized in output rather than in input. Accordingly, the controlling operation of the power by the secondary current Is, instead of the power controlling by the input current Iᵢₙ, has an effect that a stabler power control may be effected by a portion closer the output. It is needless to say that means for the controlling operation by the anode current IA of the magnetron has the same effect.

## Claims

1. A power supply for a magnetron (23) comprising a d.c. power supply (12), an inverter (15) having at least one switching element (17) for converting the output of the d.c. power supply into a high frequency voltage, a drive circuit (19) for the inverter, and a transformer (20) which boosts the output of the inverter (15) to feed power to the magnetron (23);
the transformer (20) comprising a primary winding (21) to be connected with the inverter (15), a secondary winding (22) for feeding high-tension high-frequency power to the magnetron (23), a tertiary winding (24) for feeding low-tension high-frequency to the cathode heater (23a) of the magnetron (23), and a fourth winding (33) for providing a voltage signal to the drive circuit (19) for controlling the output voltage of the inverter;
further comprising a current sensor (25, 53) for providing a current signal to the drive circuit (19) for controlling the output current of the inverter (15);
characterized in that
the drive circuit (19) provides an output signal that sets the current supplied through the inverter (15) to a lower value if the output voltage of the inverter is above a given value, and to a higher value if the output voltage is below a given value; and
that the coupling coefficient (K24) between the fourth winding (33) and the secondary winding (22) is larger than the coupling coefficient (K14) between the fourth winding (33) and the primary winding (21).

2. A power supply for a magnetron (23) described in claim 1, wherein secondary winding (22) is provided between the fourth winding (33) and the primary winding (21).

3. A power supply for a magnetron described in claim 1 or claim 2, wherein a flat film winding is used for the fourth winding (33).

4. A power supply for a magnetron described in claim 1, wherein the fourth winding (33) is provided with a fuse (39) operable if a current of a given value or more flows to the fourth winding (33).

5. A power supply for a magnetron described in claim 1, wherein an intermediate terminal (48) is provided on the secondary winding (22) of the transformer (20) to construct the fourth winding (33).

6. A power supply for a magnetron described in claim 1, wherein the windings, wound on the same leg of the core (40, 41) of the transformer (20), are arranged in the order of primary winding (21), secondary winding (22), tertiary winding (24), fourth winding (33).

7. A power supply for a magnetron described in claim 6, wherein the space (l3) between the tertiary winding (24) and the fourth winding (33) is larger than the space (l2) between the secondary winding (22) and the tertiary winding (24).

8. A power supply for a magnetron described in claims 1 and 6, wherein the core (40, 41) of the transformer (20) is provided with a gap (43), which is provided near the primary winding.

9. A power supply for a magnetron described in claim 6, wherein the space (l1) between the primary winding (21) and the secondary winding (22) is larger than the space (l2) between the secondary winding (22) and the tertiary winding (24).

10. A power supply for a magnetron described in claim 1, wherein one terminal of the secondary winding (22) has the same potential as the core (40, 41) of the transformer (20).

11. A power supply for a magnetron described in claim 1, wherein the output of the secondary winding (22) is rectified through a half wave rectifier to apply it to the magnetron (23).

12. A power supply for a magnetron described in claim 1, wherein the core (40, 41) of the transformer (20) is provided with a gap (43) integral with the bobbin (46) of the primary winding (21).

13. A power supply for a magnetron described in claim 1, wherein the secondary winding (22) is division-wound.

14. A power supply for a magnetron described in claim 1, wherein litz wire is used for the primary winding (21).

## Patentansprüche

1. Stromversorgung für ein Magnetron
mit einer Gleichspannungsquelle (12); einem Wechselrichter (15), der mindestens ein Schaltelement (17) aufweist, zum Umwandeln der Gleichspannung der Gleichspannungsquelle in eine Hochfrequenzspannung; einer Treiberschaltung (19) für den Wechselrichter; und einem Transformator, der die Ausgangsspannung des Wechselrichters (15) hochspannt, um dem Magnetron (23) Leistung zuzuführen;
wobei der Transformator (20) eine an den Wechselrichter (15) angeschlossene Primärwicklung (21), eine Sekundärwicklung (22) zur Speisung des Magnetrons (23) mit Hochspannungs-Hochfrequenzenergie, eine dritte Wicklung (24) zur Speisung der Kathodenheizung (23a) des Magnetrons (23) mit Niederspannungs-Hochfrequenzenergie und eine vierte Wicklung (33) zur Lieferung eines Spannungssignals an die Treiberschaltung (19) zur Steuerung der Ausgangsspannung des Wechselrichters aufweist;
mit einem Stromsensor (25, 53) zur Lieferung eines Stromsignals an die Treiberschaltung (19) zur Steuerung des Ausgangsstroms des Wechselrichters (15);
dadurch gekennzeichnet, daß
die Treiberschaltung (19) ein Ausgangssignal liefert, das den durch den Wechselrichter (15) abgegebenen Strom auf einen niedrigen Wert einstellt, wenn die Ausgangsspannung des Wechselrichters oberhalb eines gegebenen Wertes liegt, und auf einen höheren Wert einstellt, wenn die Ausgangsspannung unterhalb eines gegebenen Wertes liegt; und
daß der Kopplungsgrad (K24) zwischen der vierten Wicklung (33) und der Sekundärwicklung (22) größer als der Kopplungsgrad (K14) zwischen der vierten Wicklung (33) und der Primärwicklung (21) ist.

2. Stromversorgung für ein Magnetron (23) nach Anspruch 1,
dadurch gekennzeichnet, daß die Sekundärwicklung (22) zwischen der vierten Wicklung (33) und der Primärwicklung (21) angeordnet ist.

3. Stromversorgung für ein Magnetron nach Anspruch 1 oder 2,
dadurch gekennzeichnet, daß die vierte Wicklung (33) eine flache Folienwicklung ist.

4. Stromversorgung für ein Magnetron nach Anspruch 1,
dadurch gekennzeichnet, daß die vierte Wicklung (33) mit einer Sicherung (39) versehen ist, die anspricht, wenn die vierte Wicklung (33) einen Strom bestimmter Größe oder darüber führt.

5. Stromversorgung für ein Magnetron nach Anspruch 1,
dadurch gekennzeichnet, daß die Sekundärwicklung (22) des Transformators (20) mit einer Anzapfung (48) versehen ist, um die vierte Wicklung (33) zu bilden.

6. Stromversorgung für ein Magnetron nach Anspruch 1,
dadurch gekennzeichnet, daß die Wicklungen, die auf denselben Schenkel des Kerns (40, 41) des Transformators (20) gewickelt sind, in folgender Reihenfolge angeordnet sind: Primärwicklung (21), Sekundärwicklung (22), dritte Wicklung (24), vierte Wicklung (33).

7. Stromversorgung für ein Magnetron nach Anspruch 6,
dadurch gekennzeichnet, daß der Abstand (l3) zwischen der dritten Wicklung (24) und der vierten Wicklung (33) größer ist als der Abstand (l2) zwischen der Sekundärwicklung (22) und der dritten Wicklung (24).

8. Stromversorgung für ein Magnetron nach den Ansprüchen 1 und 6,
dadurch gekennzeichnet, daß der Kern (40, 41) des Transformators (20) in der Nähe der Primärwicklung mit einem Luftspalt (43) versehen ist.

9. Stromversorgung für ein Magnetron nach Anspruch 6,
dadurch gekennzeichnet, daß der Abstand (l1) zwischen der Primärwicklung (21) und der Sekundärwicklung (22) größer ist als der Abstand (l2) zwischen der Sekundärwicklung (22) und der dritten Wicklung (24).

10. Stromversorgung für ein Magnetron nach Anspruch 1,
dadurch gekennzeichnet, daß ein Anschluß der Sekundärwicklung (22) das gleiche Potential wie der Kern (40, 41) des Transformators (20) aufweist.

11. Stromversorgung für ein Magnetron nach Anspruch 1,
dadurch gekennzeichnet, daß die Ausgangsspannung der Sekundärwicklung (22) über einen Halbweggleichrichter gleichgerichtet und dem Magnetron (23) zugeführt wird.

12. Stromversorgung für ein Magnetron nach Anspruch 1,
dadurch gekennzeichnet, daß der Kern (40, 41) des Transformators (20) mit einem Luftspalt (43) versehen ist, der durch den Spulenkörper (46) der Primärwicklung (21) gebildet wird.

13. Stromversorgung für ein Magnetron nach Anspruch 1,
dadurch gekennzeichnet, daß die Sekundärwicklung (22) als aufgeteilte Wicklung ausgebildet ist.

14. Stromversorgung für ein Magnetron nach Anspruch 1,
dadurch gekennzeichnet, daß für die Primärwicklung (21) Litzendraht verwendet ist.

## Revendications

1. Alimentation de puissance pour un magnétron (23) comprenant une alimentation de puissance A courant continu (12), un inverseur (15) possédant au moins un élément de commutation (17) pour la conversion de la sortie de l'alimentation de puissance A courant continu en une tension à haute fréquence, un circuit d'attaque (19) de l'inverseur et un transformateur (20) amplifiant la sortie de l'inverseur (15) pour alimenter en puissance le magnétron (23), le transformateur (20) comprenant un enroulement primaire (21) à raccorder à l'inverseur (15), un enroulement secondaire (22) pour fournir une puissance à haute fréquence et haute tension au magnétron (23), un enroulement tertiaire (24) pour fournir une basse tension à haute fréquence au réchauffeur de cathode (23a) du magnétron (23) et un enroulement quaternaire (33) pour fournir un signal de tension au circuit d'attaque (19) pour la commande de la tension de sortie de l'inverseur;
alimentation comprenant, de plus, un capteur de courant (25, 53) pour fournir un signal de courant au circuit d'attaque (19) pour la commande du courant de sortie de l'inverseur (15);
alimentation caractérisée en ce que le circuit d'attaque (19) fournit un signal de sortie réglant le courant fourni à travers l'inverseur (15) à une valeur plus faible si la tension de sortie de l'inverseur est supérieure à une valeur donnée et à une valeur plus haute si la tension de sortie est inférieure à une valeur donnée et en ce que le coefficient de couplage (K24) entre l'enroulement quaternaire (33) et l'enroulement secondaire (22) est supérieur au coefficient de couplage (K14) entre l'enroulement quaternaire (33) et l'enroulement primaire (21).

2. Alimentation de puissance pour un magnétron (23) selon la revendication 1, dans laquelle l'enroulement secondaire (22) est prévu entre l'enroulement quaternaire (33) et l'enroulement primaire (21).

3. Alimentation de puissance pour un magnétron (23) selon la revendication 1 ou 2, dans laquelle un enroulement à film plat est utilisé pour l'enroulement quaternaire (33).

4. Alimentation de puissance pour un magnétron (23) selon la revendication 1, dans laquelle l'enroulement quaternaire (33) est muni d'un fusible (39) actionnable si un courant d'une valeur donnée ou plus traverse l'enroulement quaternaire (33).

5. Alimentation de puissance pour un magnétron (23) selon la revendication 1, dans laquelle une borne intermédiaire (48) est prévue sur l'enroulement secondaire (22) du transformateur (20) pour agencer l'enroulement quaternaire (33).

6. Alimentation de puissance pour un magnétron (23) selon la revendication 1, dans laquelle les enroulements, effectués sur la même jambe du noyau (40, 41) du transformateur (20), sont disposés dans l'ordre suivant : enroulement primaire (21), enroulement secondaire (22), enroulement tertiaire (24) et enroulement quaternaire (33).

7. Alimentation de puissance pour un magnétron (23) selon la revendication 6, dans laquelle l'espace (ℓ3) séparant l'enroulement tertiaire (24) et l'enroulement quaternaire (33) est supérieur à l'espace (ℓ2) séparant l'enroulement secondaire (22) et l'enroulement tertiaire (24).

8. Alimentation de puissance pour un magnétron (23) selon les revendications 1 et 6, dans laquelle le noyau (40, 41) du transformateur (20) présente un intervalle (43) qui est prévu près de l'enroulement primaire.

9. Alimentation de puissance pour un magnétron (23) selon la revendication 6, dans laquelle l'espace (ℓ1) séparant l'enroulement primaire (21) et l'enroulement secondaire (22) est supérieur à l'espace (ℓ2) séparant l'enroulement secondaire (22) et l'enroulement tertiaire (24).

10. Alimentation de puissance pour un magnétron (23) selon la revendication 1, dans laquelle une borne de l'enroulement secondaire (22) est au même potentiel que le noyau (40, 41) du transformateur (20).

11. Alimentation de puissance pour un magnétron (23) selon la revendication 1, dans laquelle la sortie de l'enroulement secondaire (22) est redressée via un redresseur demi-onde pour l'appliquer au magnétron (23).

12. Alimentation de puissance pour un magnétron (23) selon la revendication 1, dans laquelle le noyau (40, 41) du transformateur (20) présente un intervalle (43) intégral au bobinage (46) de l'enroulement primaire (21).

13. Alimentation de puissance pour un magnétron (23) selon la revendication 1, dans laquelle l'enroulement secondaire (22) est un enroulement à division.

14. Alimentation de puissance pour un magnétron (23) selon la revendication 1, dans laquelle on utilise un fil de "litz" pour l'enroulement primaire (21).
